(19) Europäisches Patentamt / European Patent Office / Office européen des brevets

(11) **EP 4 108 945 A1**

(12) **EUROPEAN PATENT APPLICATION**
published in accordance with Art. 153(4) EPC

(43) Date of publication:
**28.12.2022 Bulletin 2022/52**

(21) Application number: **21757336.9**

(22) Date of filing: **10.02.2021**

(51) International Patent Classification (IPC):
**F16C 32/04** (2006.01)     **G01B 7/00** (2006.01)
**G01D 5/12** (2006.01)     **H03B 1/04** (2006.01)
**F04D 19/04** (2006.01)

(52) Cooperative Patent Classification (CPC):
**F04D 19/04; F16C 32/04; G01B 7/00; G01D 5/12;
H03B 1/04;** Y02E 40/40

(86) International application number:
**PCT/JP2021/005104**

(87) International publication number:
**WO 2021/166778 (26.08.2021 Gazette 2021/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.02.2020 JP 2020024767**

(71) Applicant: **Edwards Japan Limited
Yachiyo-shi, Chiba 276-8523 (JP)**

(72) Inventor: **KAWASHIMA Toshiaki
Yachiyo-shi Chiba 276-8523 (JP)**

(74) Representative: **Openshaw & Co.
8 Castle Street
Farnham, Surrey GU9 7HR (GB)**

(54) **HARMONIC ELIMINATION CIRCUIT, POSITION DETECTION DEVICE, MAGNETIC BEARING DEVICE AND VACUUM PUMP**

(57)     Provided are a harmonic elimination circuit that eliminates harmonics generated in a synchronous detection circuit without using a high-cost component to achieve low vibration and low noise, a position detection device, a magnetic bearing device, and a vacuum pump. An odd-order harmonic of a sensor carrier frequency can be eliminated from a displacement signal after detection by setting a duty of a switch of the synchronous detection circuit to a specified value. Conditions for a pulse generation method are basically adjusted so as to generate a pulse at a phase angle of 180 degrees + 360 degrees x n (n is a positive integer including 0). In addition, a duty of a pulse for a synchronous detection switch is set such that a positive-side area and a negative-side area of a harmonic waveform are equal to each other. Moreover, the pulse duty is adjusted such that the phase angle at which a sensor signal has a highest sensitivity is centered. In other words, when the sensor signal is a 360-degree sine wave, the duty of the pulse is preferably adjusted around phase angles of 90 degrees and 270 degrees.

FIG. 1

**Description**

The present invention relates to a harmonic elimination circuit, a position detection device, a magnetic bearing device, and a vacuum pump, and particularly relates to a harmonic elimination circuit that eliminates harmonics generated in a synchronous detection circuit without using high-cost components to achieve low vibration and low noise, a position detection device, a magnetic bearing device, and a vacuum pump.

With recent development of electronics, demand for semiconductors such as a memory and an integrated circuit has drastically increased. These semiconductors are manufactured through doping of extremely pure semiconductor substrates with impurities for giving electrical properties thereto, formation of minute circuit patterns on the semiconductor substrates, stacking of the circuit patterns, and the like. These operations are required to be performed in a chamber in a high vacuum state to avoid effects of dust in air or the like. To exhaust the chamber, a vacuum pump is generally used as a pump device and, in particular, a turbo molecular pump, which is among vacuum pumps, is used frequently in terms of a small amount of residual gas, ease of maintenance, and the like.

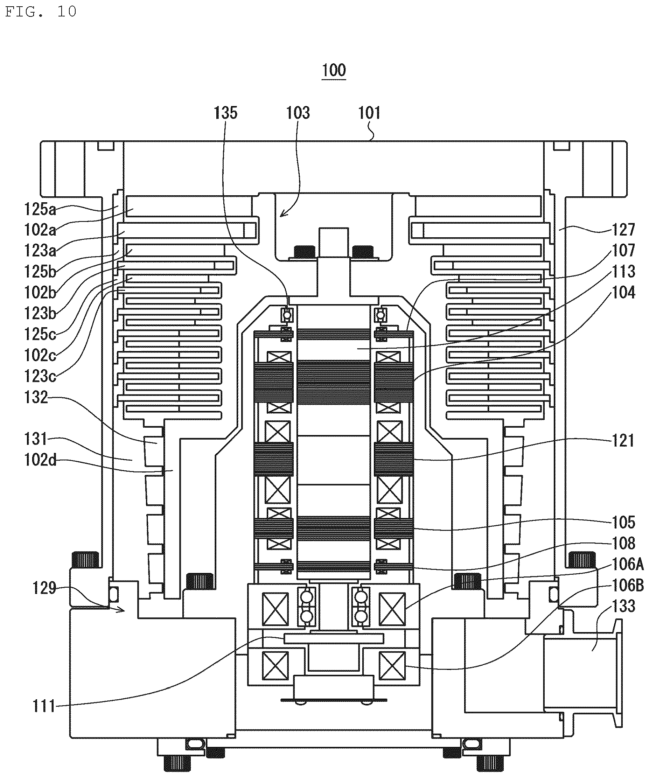

Semiconductor manufacturing steps include a large number of steps of applying various process gases to a semiconductor substrate, and the turbo molecular pump is used not only to internally evacuate a chamber, but also to exhaust these process gases from the chamber. The turbo molecular pump is used also to bring an environment in a chamber of an electronic microscope or the like into a high vacuum state in equipment such as the electronic microscope in order to prevent refraction of an electronic beam or the like due to the presence of dust or the like. FIG. 10 shows a longitudinal cross-sectional view of the turbo molecular pump.

In FIG. 10, in a turbo molecular pump 100, an inlet port 101 is formed in an upper end of a cylindrical external cylinder 127. In addition, inside the external cylinder 127, a rotating body 103 having a plurality of rotor blades 102a, 102b, 102c, ... formed of turbine blades for attracting and exhausting a gas is provided. The rotor blades 102a, 102b, 102c, ... are formed radially and in multiple stages around a peripheral portion of the rotating body 103. At a center of this rotating body 103, a rotor shaft 113 is provided, and the rotor shaft 113 is held to be suspended in the air and position-controlled by, e.g., a 5-axis controlled magnetic bearing.

Upper radial electromagnets 104 include four electromagnets arranged in pairs on X- and Y-axes and in positive and negative directions (the positive-side electromagnets are referred to as upper radial electromagnets 104+, while the negative-side electromagnets are referred to as upper radial electromagnets 104-, though not shown in the drawing). In proximity and correspondence to the upper radial electromagnets 104, an upper radial sensor 107 including four electromagnets is provided.

The upper radial sensor 107 is a so-called differential inductance-type sensor that detects respective positions of the rotor shaft 113 in an X-axis direction and in a Y-axis direction in two directions including a positive direction and a negative direction. The upper radial sensor 107 is configured to output a sensor signal corresponding to radial positions of the rotor shaft 113 to a magnetic bearing control unit (the illustration of which is omitted) such as a control device. The magnetic bearing control unit is configured to control excitation of the upper radial electromagnets 104 on the basis of the sensor signal from the upper radial sensor 107 and adjust the upper radial position of the rotor shaft 113.

The rotor shaft 113 is formed of a high-magnetic-permeability material (such as iron) or the like to be magnetically attracted by the upper radial electromagnets 104. Such adjustment is performed independently in each of the X-axis direction and the Y-axis direction.

Lower radial electromagnets 105 also include four electromagnets arranged in pairs on the X- and Y-axes and in positive and negative directions (the positive-side electromagnets are referred to as lower radial electromagnets 105+, while the negative-side electromagnets are referred to as lower radial electromagnets 105-, though not shown in the drawing). In addition, in proximity and correspondence to the lower radial electromagnets 105, a lower radial sensor 108 including four electromagnets is provided.

The lower radial sensor 108 is also a differential inductance-type sensor and, by the magnetic bearing control unit (the illustration of which is omitted) such as the control device, the lower radial position of the rotor shaft 113 is adjusted.

In addition, axial electromagnets 106 are disposed with a disc-shaped metal disc 111 provided below the rotor shaft 113 being vertically interposed therebetween (the upper electromagnet in FIG. 10 is referred to as a negative axial electromagnet 106A, while the lower electromagnet therein is referred to as a positive axial electromagnet 106B). The negative axial electromagnet 106A is configured to magnetically attract the metal disc 111 toward the inlet port 101, while the positive axial electromagnet 106B is configured to magnetically attract the metal disc 111 toward a base portion 129. The metal disc 111 is formed of a high-magnetic-permeability material such as iron.

In the base portion 129 provided at a bottom portion of the external cylinder 127, an axial sensor not shown and intended to detect an axial position Z of the rotor shaft 113 is provided. The axial sensor is configured to detect a position of a sensor target not shown and embedded in a lower end portion of the rotor shaft 113 to detect the axial position Z of the rotor shaft 113 and output a sensor signal corresponding to the axial position Z to the magnetic bearing control unit such as the control device.

Then, the magnetic bearing control unit controls excitation of the axial electromagnets 106 on the basis of the sensor signal from the axial sensor and appropriately adjust a magnetic force exerted by the axial electromagnets 106 on the metal disc 111 to magnetically suspend the rotor shaft 113 and hold the rotor shaft 113 in space in non-contact relation.

Meanwhile, a motor 121 includes a plurality of magnetic poles arranged in a circular configuration so as to surround the rotor shaft 113. Each of the magnetic poles is controlled by the control device so as to rotationally drive the rotor shaft 113 via an electromagnetic force operating between the magnetic pole and the rotor shaft 113. In the motor 121, a rotation speed sensor not shown is embedded, and a rotation speed of the rotor shaft 113 is detected on the basis of a detection signal from the rotation speed sensor. In the vicinity of the lower radial sensor 108, a phase sensor not shown is further mounted so as to detect a phase of rotation of the rotor shaft 113.

A plurality of stator blades 123a, 123b, 123c, ... are disposed to be spaced apart by narrow gaps from the rotor blades 102a, 102b, 102c, .... Each of the rotor blades 102a, 102b, 102c, ... downwardly transfers molecules of an exhaust gas through a collision, and is accordingly formed to be inclined at a predetermined angle from a plane perpendicular to an axial line of the rotor shaft 113. Likewise, each of the stator blades 123 is also formed to be inclined at a predetermined angle from a plane perpendicular to the axial line of the rotor shaft 113, and are disposed in layers alternating with layers of the rotor blades 102 to internally extend in the external cylinder 127.

The stator blades 123 have one ends which are supported, while being inserted between a plurality of stator blade spacers 125a, 125b, 125c, ... stacked in layers. Each of the stator blade spacers 125 is a ring-shaped member and formed of a metal such as, e.g., aluminum, iron, stainless steel, or copper or of a metal containing such a metal as a component, such as an alloy.

To an outer periphery of each of the stator blade spacers 125, the external cylinder 127 is fixed to be spaced apart by a narrow gap therefrom. In addition, between the lowermost stator blade spacer 125 and the base portion 129 provided at the bottom portion of the external cylinder 127, a threaded spacer 131 is disposed. In the base portion 129 below the threaded spacer 131, an outlet port 133 is formed to communication with the outside. The threaded spacer 131 is a cylindrical member formed of a metal such as aluminum, copper, stainless steel or of a metal containing such a metal as a component, such as an alloy. In an inner peripheral surface of the threaded spacer 131, a plurality of spiral thread grooves 132 are engraved. Spiral directions of the thread grooves 132 are directions in which the molecules of the exhaust gas are transferred toward the outlet port 133 when the molecules move in a direction of rotation of the rotating body 103.

In a lowermost portion of the rotating body 103 subsequent to the rotor blades 102a, 102b, 102c, ..., the rotor blade 102d is suspended downward. An outer peripheral surface of the rotor blade 102d has a cylindrical shape and protrudes toward an inner peripheral surface of the threaded spacer 131 to be close to and spaced apart by a predetermined gap from the inner peripheral surface of the threaded spacer 131.

The base portion 129 is a disc-shaped member forming a base bottom portion of the turbo molecular pump 100, and is generally formed of a metal such as iron, aluminum, or stainless steel.

In such a configuration, when the rotor blades 102 are driven by the motor 121 to rotate together with the rotor shaft 113, by the operation of the rotor blades 102 and the stator blades 123, the exhaust gas from the chamber is sucked through the inlet port 101. The exhaust gas sucked from the inlet port 101 is transferred to the base portion 129 through between the rotor blades 102 and the stator blades 123. At this time, frictional heat generated when the exhaust gas comes into contact with the rotor blades 102, conduction of heat generated in the motor 121, or the like increases a temperature of the rotor blades 102, and the heat is transferred toward the stator blades 123 by radiation or conduction by gas molecules of the exhaust gas or the like.

The stator blade spacers 125 are joined together at outer peripheral portions thereof, and transfer the heat received by the stator blades 123 from the rotor blades 102, the frictional heat generated when the exhaust gas comes into contact with the stator blades 123, or the like to the outside. Then, the exhaust gas transferred to the base portion 129 is transmitted to the outlet port 133, while being guided by a thread groove 131a of the threaded spacer 131.

Next, a description will be given of a position detection circuit including the upper radial sensor 107 and the lower radial sensor 108 each configured as described above.

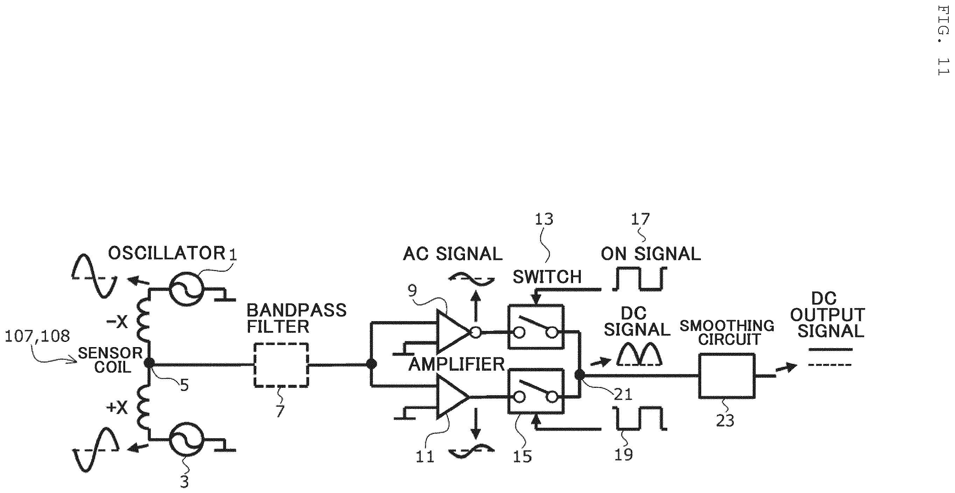

In FIG. 11, for the upper radial sensor 107 and the lower radial sensor 108, respective inductance sensors are used. To respective one ends of a positive-direction coil and a negative-direction coil, oscillators 1 and 3 are attached. From the oscillators 1 and 3, a carrier frequency as a given frequency is applied to the coils, and an AC signal corresponding to a displacement is generated.

Other ends of the coils are connected at a middle point 5, and a differential voltage extracted at the middle point 5 is input to an inverting amplifier 9 and to a non-inverting amplifier 11 via a bandpass filter 7. The bandpass filter 7 is disposed so as to eliminate signals in a high-frequency region other than a band frequency including a fundamental frequency of the oscillators 1 and 3. At an output of the inverting amplifier 9, an inverting switch 13 is disposed while, at an output of the non-inverting amplifier 11, a non-inverting switch 15 is disposed.

To the inverting switch 13, an operation signal 17 that turns ON the inverting switch 13 only when a phase angle is between 0 and 180 degrees in synchronization with the carrier frequency is input. Accordingly, an AC signal inverted by the inverting amplifier 9 passes through the inverting switch 13 only when the phase angle is between 0 to 180 degrees.

Meanwhile, to the non-inverting switch 15, an operation signal 19 that turns ON the non-inverting switch 15 only when a phase angle is between 180 to 360 degrees in synchronization with the carrier frequency is input. Accordingly, the AC signal output from the non-inverting amplifier 11 passes through the non-inverting switch 15 only when the phase angle is between 180 and 360 degrees.

At a connection point 21, the signal having passed through the inverting switch 13 and the signal having passed through the non-inverting switch 15 are added up to result in a dc signal. The dc signal is smoothed by a smoothing circuit 23. The signal smoothed by the synchronous detection circuit is output as a position signal to the magnetic bearing control unit to be used for position control, as described above (See Japanese Patent Application Publication No. 2006-317419).

During operation of a magnetic bearing, respective power amplifiers that drive the upper radial electromagnets 104, the lower radial electromagnets 105, and the axial electromagnets 106 and an inverter for driving the motor 121 perform PWM control over power, and consequently a large amount of switching noise is generated.

The noise contaminates the displacement sensor signal to appear as noise components other than the original displacement in an output of the synchronous detection circuit and cause undesirable vibration and noise.

The synchronous detection method using the switches that are alternately tuned ON/OFF every 180 degrees described above is characterized in that, in addition to a displacement signal included in a fundamental wave component of the carrier frequency, an odd-order harmonic noise component of the carrier frequency is also converted to a displacement signal.

The present invention has been achieved in view of such conventional problems to be solved, and an object of the present invention is to provide a harmonic elimination circuit that eliminates harmonics generated in a synchronous detection circuit without using high-cost components to achieve low vibration and low noise, a position detection device, a magnetic bearing device, and a vacuum pump.

Accordingly, an aspect of the present invention (claim 1) is a harmonic elimination circuit that eliminates a harmonic signal from an ac waveform signal on which the harmonic signal is superimposed, wherein a duty of a pulse synchronized with the ac waveform signal is set such that a positive-side area and a negative-side area of the harmonic signal are equal to each other.

When the ac waveform signal is multiplied by the pulse, an odd-order harmonic is undesirably generated. However, as a result of setting the duty of the pulse synchronized with the ac waveform signal such that the positive-side area and the negative-side area of the harmonic signal are equal to each other, the positive-side signal and the negative-side signal of the odd-order harmonic are cancelled out. As a result, a component of the odd-order harmonic disappears.

In the harmonic elimination circuit according to the aspect of the present invention (claim 2), the duty of the pulse is generated through switching to any of an output resulting from inverting amplification, an output resulting from non-inverting amplification, or a zero output.

By adding the zero output, it is easier to make such an adjustment that the positive-side area and the negative-side area of the harmonic signal are equal to each other. Consequently, there is no need to add a high-cost component, and it is possible to implement the low-vibration and low-noise magnetic bearing device without increasing cost.

In the harmonic elimination circuit according to the aspect of the present invention (claim 3), the pulse includes at least one pulse during a half period of the ac waveform signal, and the duty of the pulse is symmetrically generated with respect to a peak value of the ac waveform signal in a phase progression direction.

The duty of the pulse symmetrically generated with respect to the peak value of the ac waveform signal in the phase progression direction allows a signal waveform to be most efficiently extracted, and also allows a harmonic to be accurately eliminated. In addition, the pulse can easily be generated.

In the harmonic elimination circuit according to the aspect of the present invention (claim 4), to eliminate a third-order harmonic, the pulse is generated from one pulse having a duty of $2\Pi/3$ [rad] during the half period of the ac waveform signal.

By generating the duty of $2\Pi/3$ [rad] from the one pulse during the half period of the ac waveform signal, it is possible to eliminate the third-order harmonic with a simple configuration.

In the harmonic elimination circuit according to the aspect of the present invention (claim 5), to eliminate a fifth-order harmonic, the pulse is generated from one pulse having a duty of $4\Pi/5$ [rad] during the half period of the ac waveform signal.

By generating the duty of $4\Pi/5$ [rad] from the one pulse during the half period of the ac waveform signal, it is possible to eliminate the fifth-order harmonic with a simple configuration.

In the harmonic elimination circuit according to the aspect of the present invention (claim 6), to eliminate a seventh-order harmonic, the pulse is generated from one pulse having a duty of $6\Pi/7$ [rad] during the half period of the ac waveform signal.

By generating the duty of 6Π/7 [rad] from the one pulse during the half period of the ac waveform signal, it is possible to eliminate the seventh high-order harmonic with a simple configuration.

In the harmonic elimination circuit according to the aspect of the present invention (claim 7), to simultaneously eliminate a third-order harmonic and a fifth-order harmonic, the pulse is generated from three pulses each having a duty of 2Π/3 [rad] during the half period of the ac waveform signal.

By generating the duty of 2Π/3 [rad] from the three pulses during the half period of the ac waveform signal, it is possible to eliminate the third-order harmonic and the fifth-order harmonic with a simple configuration.

In the harmonic elimination circuit according to the aspect of the present invention (claim 8), to simultaneously eliminate a third-order harmonic and a seventh-order harmonic, the pulse is generated from three pulses each having a duty of 2Π/3 [rad] during the half period of the ac waveform signal.

By generating the duty of 2Π/3 [rad] from the three pulses during the half period of the ac waveform signal, it is possible to eliminate the third-order harmonic and the seventh-order harmonic with a simple configuration.

In the harmonic elimination circuit according to the aspect of the present invention (claim 9), to simultaneously eliminate a third-order harmonic, a fifth-order harmonic, and a seventh-order harmonic, the pulse is generated from seven pulses each having a duty of 2Π/3 [rad] during the half period of the ac waveform signal.

By generating the duty of 2Π/3 [rad] from the seven pulses during the half period of the ac waveform signal, it is possible to eliminate the third-order harmonic, the fifth-order harmonic, and the seventh-order harmonic with a simple configuration.

In the harmonic elimination circuit according to the aspect of the present invention (claim 10), as the duty of the pulse, a duty that generates a sine wave PWM is used.

As a result, the duty of the pulse is generated with a simple configuration to allow harmonic noise to be eliminated.

In the harmonic elimination circuit according to the aspect of the present invention (claim 11), a switch that disconnects and connects power is controlled with timing of the zero output.

In the present invention, there is a zero output (no input) mode in which a signal is not transmitted to an output. Accordingly, by turning ON/OFF the switch that disconnects and connects the power during a zero-output period, it is possible to prevent spike noise from contaminating the signal.

Another aspect of the present invention (claim 12) is a position detection device including: a position detection unit that detects a position of an object; a carrier-wave-signal supply unit that supplies a carrier wave signal to the position detection unit; and a detection unit that detects a position signal resulting from the detection by the position detection unit through switching using a switch synchronized with the carrier wave signal, wherein the position signal is formed of an ac waveform signal on which a harmonic signal is superimposed, and a duty of a pulse that drives the switch is set such that a positive-side area and a negative-side area of the harmonic signal are equal to each other.

Still another aspect of the present invention (claim 13) is a magnetic bearing device including: a position detection unit that detects a position of an object in non-contact relation; a magnetic bearing unit that controls the position of the object by using an electromagnet; a carrier-wave-signal supply unit that supplies a carrier wave signal to the position detection unit; and a detection unit that detects a position signal resulting from the detection by the position detection unit through switching using a switch synchronized with the carrier wave signal, wherein the position signal is formed of an ac waveform signal on which a harmonic signal is superimposed, and a duty of a pulse that drives the switch is set such that a positive-side area and a negative-side area of the harmonic signal are equal to each other.

Yet another aspect of the present invention (claim 14) is a vacuum pump including: a rotating body; a position detection unit that detects a position of the rotating body in non-contact relation; a magnetic bearing unit that controls the position of the rotating body by using an electromagnet; a carrier-wave-signal supply unit that supplies a carrier wave signal to the position detection unit; and a detection unit that detects a position signal resulting from the detection by the position detection unit through switching using a switch synchronized with the carrier wave signal, wherein the position signal is formed of an ac waveform signal on which a harmonic signal is superimposed, and a duty of a pulse that drives the switch is set such that a positive-side area and a negative-side area of the harmonic signal are equal to each other.

As described above, according to the present invention, the duty of the pulse synchronized with the ac waveform signal is configured such that the positive-side area and the negative-side area of the harmonic signal are equal to each other. Accordingly, a positive-side signal and a negative-side signal of an odd-order harmonic are cancelled out. As a result, a component of the odd-order harmonic disappears.

FIG. 1 is a diagram of a position detection circuit as an embodiment of the present invention;
FIG. 2 is a diagram illustrating a relationship between a fundamental wave and a third-order harmonic component;
FIG. 3 illustrates an example of typical set values of a pulse width for eliminating odd-order harmonics;
FIGS. 4A to 4H are waveform charts each illustrating a relationship between a fundamental wave and a pulse duty when a pulse is set in the example of the set values in FIG. 3;
FIGS. 5A to 5D are diagrams each illustrating an example of a waveform of a sensor dc signal and a degree of elimination of the harmonic;

FIG. 6 illustrates an example of respective pulse waveforms from individual switches including an inverting switch, a zero-output switch, and a non-inverting switch within one period (0 to 2Π);

FIG. 7 illustrates an even-order harmonic noise component of a carrier frequency;

FIG. 8 is a diagram illustrating a method of generating a duty of the pulse;

FIGS. 9A and 9B are diagrams each illustrating a method of removing high-frequency switching spike noise;

FIG. 10 is a longitudinal cross-sectional view of a turbo molecular pump; and

FIG. 11 is a diagram of a conventional position detection circuit.

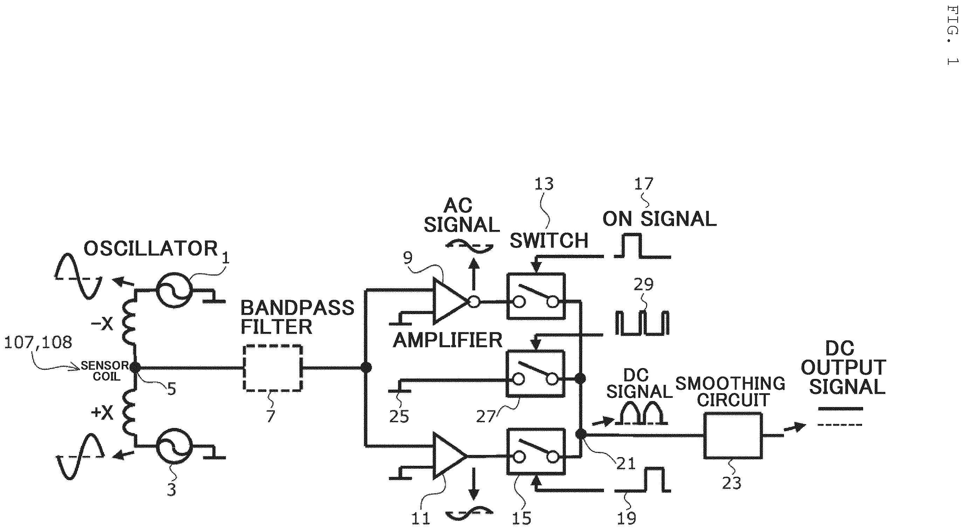

A description will be given below of an embodiment of the present invention. FIG. 1 illustrates a diagram of a position detection circuit as the embodiment of the present invention. Note that the same components as those in FIG. 11 are denoted by the same reference numerals, and a description thereof is omitted.

As can be seen from a comparison with FIG. 11 which is a diagram of a conventional position detection circuit, the position detection circuit in the embodiment of the present invention is different from the conventional position detection circuit in that a zero switch 27 is provided to have one end connected to ground 25 and another end connected to the connection point 21 between the inverting switch 13 and the non-inverting switch 15. To the zero switch 27, an operation signal 29 is input.

Next, a description will be given of effects of the embodiment of the present invention.

A synchronous detection switching operation is equivalent to multiplication between an input signal and a rectangular wave. Accordingly, in a synchronous detection output, not only a fundamental wave component originally required, but also a result of multiplication between Fourier transform f(x) of the rectangular wave shown in Numerical Expression 1 and odd-order harmonic noise appears as a dc signal.

[Math. 1]

$$f(x) = \frac{4}{\pi}\left\{sin(x) + \frac{1}{3}sin(3x) + \frac{1}{5}sin(5x) + \frac{1}{7}sin(7x) + \cdots\right\}$$

For example, when an input signal is contaminated with third-order harmonic noise of a sensor carrier frequency as shown in Numerical Expression 2, an output signal is contaminated with a noise component as shown in Numerical Expression 3.

[Math. 2]

$$Vni = Asin(3x)$$

[Math. 3]

$$Vno = \int_0^\pi (Vni \times f(x))dx \simeq \int_0^\pi \left(Asin(3x) \times \frac{4}{3\pi}sin(3x)\right)dx = \frac{2A}{3}$$

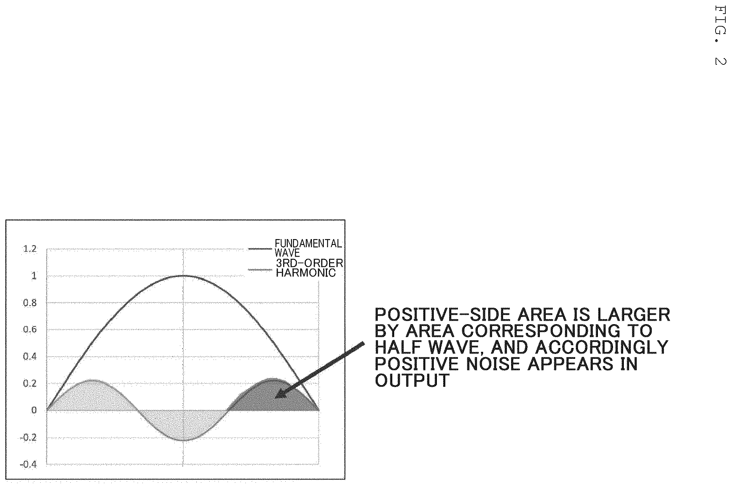

This occurs since, as illustrated in a diagram representing a relationship between a fundamental wave and a third-order harmonic component in FIG. 2, the inverting switch 13 and the non-inverting switch 15 each for the synchronous detection illustrated in FIG. 11 are turned ON during a 180-degree period corresponding to a half wave of the fundamental wave, and consequently the third-order harmonic component is integrated over 180 degrees x 3 = 540 degrees, i.e., over 1.5 periods to result in generation of a dc component.

As a solution to this problem, in the present invention, a duty of a pulse for operating each of the synchronous detection switches, the number of the pulses, and the phase of the pulse are adjusted to prevent appearance of the harmonic component in the output.

For this purpose, an input to the synchronous detection switches is changed from a conventional non-inverted-signal and inverted-signal two mode operation as illustrated in FIG. 11 to a non-inverted signal, inverted signal, and zero output (no input) three mode operation as illustrated in FIG. 1. Then, each of the pulse duties is set to a specified value. The zero output may be formation of 0 volts with a circuit, but may also be processed with software on the assumption that a signal is not received as an input to a smoothing circuit 23 during a zero-output-mode period.

The odd-order harmonics of the sensor carrier frequency can be eliminated from a displacement signal after detection by setting the duty of each of the switches of the synchronous detection circuit to a specified value.

Conditions for a pulse generation method are basically adjusted such that pulses are generated at phase angles of 180 degrees + 360 degrees x n (n is a positive integer including 0). Then, the duty of the pulse from each of the synchronous detection switches is set such that a positive-side area and a negative-side area of a harmonic waveform are equal to each other.

In addition, the duty of the pulse is adjusted such that phase angles at which a sensor signal has a highest sensitivity are centered. In other words, when the sensor signal is a 360-degree sine wave, the duty of the pulse is preferably adjusted around the phase angles of 90 degrees and 270 degrees.

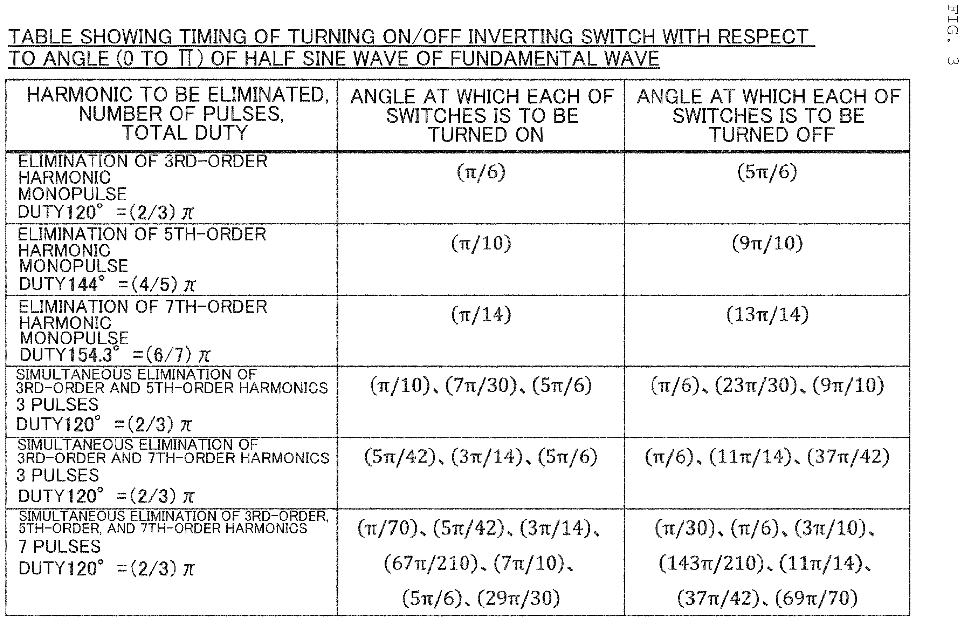

FIG. 3 illustrates an example of typical set values of a pulse width for eliminating the odd-order harmonics which are calculated on the basis of the conditions. FIG. 3 illustrates timings of turning ON/OFF the inverting switch 13 for an angle (0 to Π) of a half sine wave of a fundamental wave.

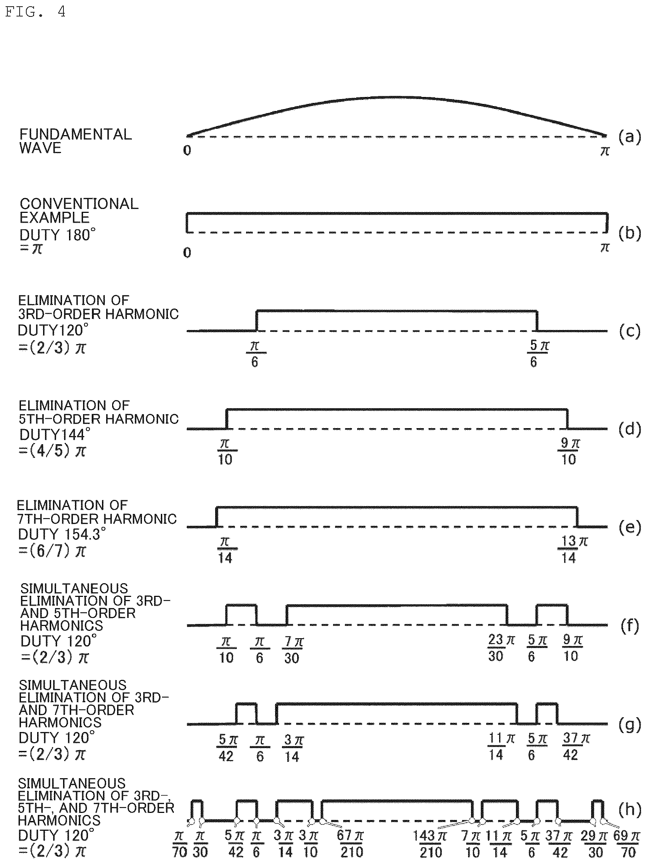

FIGS. 4A to 4H are waveform charts illustrating a relationship between the fundamental wave and the pulse duty when the pulse is set in the example of the set values in FIG. 3.

For example, when a third-order harmonic is to be eliminated, the duties in the individual modes are assumed to be such that, of phase angles of 0 to 360 degrees of a full wave of the carrier frequency, 0 to 30 degrees are for the zero output mode, 30 to 150 degrees are for the non-inverting mode, 150 to 210 degrees are for the zero output mode, 210 to 330 degrees are for the inverting mode, and 330 to 360 degrees are for the zero output mode.

Accordingly, 120 degrees (= 150 - 30 degrees) during a non-inverting operation is equivalent to 360 degrees (120 degrees x 3) in the third-order harmonic, and the third-order harmonic is sampled exactly for one period. Consequently, the third-order harmonic does not appear as positive or negative noise in the output of the synchronous detection circuit.

FIG. 4C illustrates an example in which, to eliminate such a third-order harmonic, as the switch for the synchronous detection, one pulse having a duty of 120 degrees is used.

The inverting switch 13 is turned OFF when an angle of the fundamental wave is between and including Π and 2Π.

Meanwhile, the non-inverting switch 15 is turned OFF when the angle of the fundamental wave is between and including 0 and Π. ON/OFF timing for the non-inverting switch 15 when the angle of the fundamental wave is between and including Π and 2Π is set to a value obtained by adding (Π) to the angle in the example of the set values illustrated in FIG. 3.

Note that the zero-output switch is turned ON while each of the non-inverting switch 15 and the inverting switch 13 is OFF.

As illustrated in the example of the set values in FIG. 3 and in the waveform charts in FIGS. 4A to 4H, by appropriately controlling timing for the switch for each of the modes and the number of pulses, it is possible not only to independently eliminate the third-order harmonic, the fifth-order harmonic, and the seventh-order harmonic, but also to simultaneously remove, e.g., the third- and fifth-order harmonics, the third- and seventh-order harmonics, and the third-, fifth-, and seventh-order harmonics.

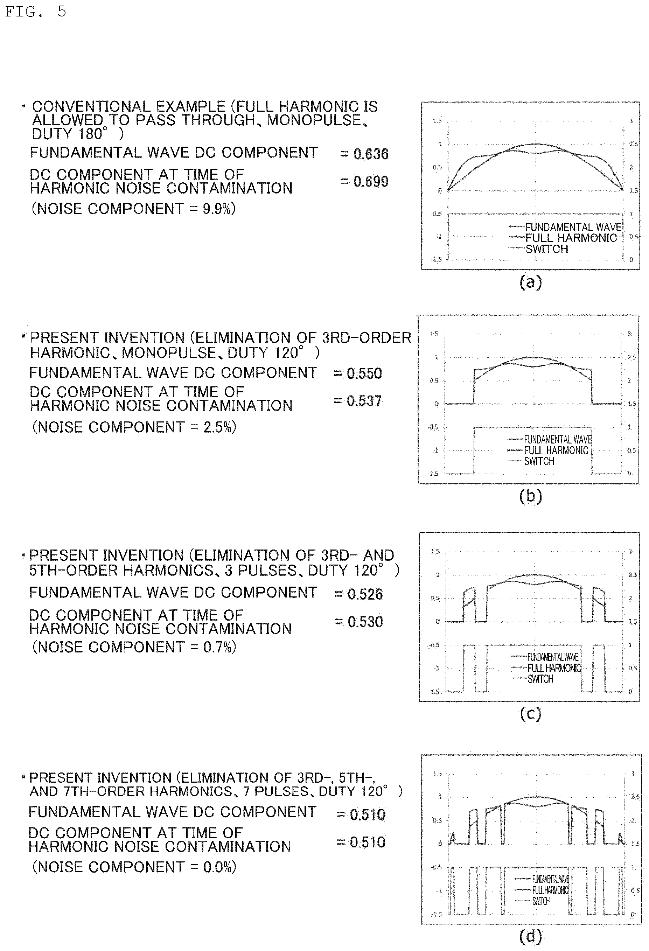

Each of FIGS. 5A to 5D illustrates an example of a waveform of a dc signal at the connection point 21 for the synchronous detection pulse set as described above and additionally illustrates a result of calculating a degree to which a high-order harmonic is eliminated. In other words, each of FIGS. 5A to 5D illustrates an example of a fundamental wave to be originally detected, a waveform when a detection duty is changed for a waveform contaminated with harmonic noise, and a value of a component of a dc signal.

As illustrated in FIG. 5A, conventional control uses a monopulse having a duty of 180 degrees. At this time, a dc component of the fundamental wave is 0.636, while a dc component at the time of harmonic noise contamination is 0.699, and a 9.9% noise component is included. Meanwhile, as illustrated in FIG. 5B, to eliminate the third-order harmonic, the present embodiment uses a monopulse having a duty of 120 degrees. As a result, the dc component of the fundamental wave is 0.550, while the dc component at the time of harmonic noise contamination is 0.537, and a 2.5% noise component is included. Thus, the harmonic noise can be reduced to about 1/4 of that in the conventional example.

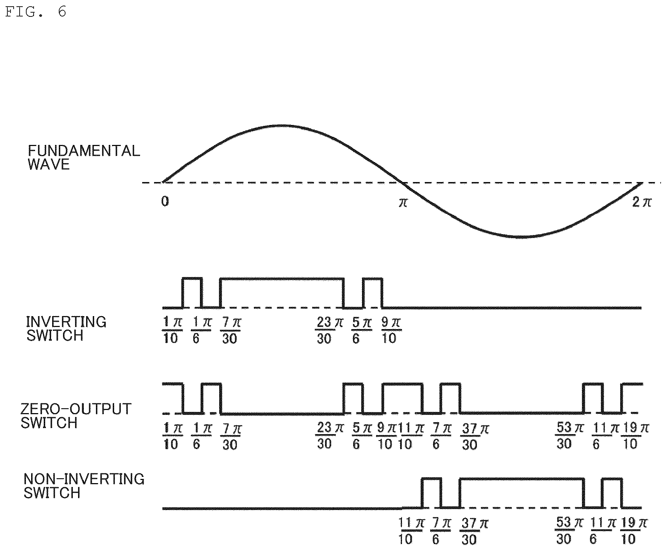

In FIG. 5C, to eliminate the third-order harmonic and the fifth-order harmonics, three pulses each having a duty of 120 degrees are used, as illustrated in the drawing. Pulse waveforms for the individual switches including the inverting switch, the zero-output switch, and the non-inverting switch in one period (0 to 2Π) at this time are illustrated in FIG. 6.

As a result, the dc component of the fundamental wave is 0.526, while the dc component at the time of harmonic noise contamination is 0.530, and a 0.7% noise component is included. Thus, the noise component can drastically be reduced to about 7% of that in the conventional example. Meanwhile, in FIG. 5D, to eliminate the third-order harmonic, the fifth-order harmonic, and the seventh-order harmonic, seven pulses each having a duty of 120 degrees are used, as illustrated in the drawing. As a result, the dc component of the fundamental wave is 0.510, while the dc component at the time of harmonic noise contamination is 0.510, and the noise component can be reduced to 0.0%.

Thus, it will be understood that, by appropriately setting the duty of the synchronous detection pulse, it is possible to efficiently eliminate the harmonic noise.

Note that, when the third-order harmonic is eliminated, odd-order harmonics related to the third-order harmonic are also simultaneously eliminated. In other words, 3rd-order x 3 = 9th-order harmonic, 3rd-order x 5 = 15th-order harmonic, ... and the like are simultaneously eliminated. Likewise, when the fifth-order harmonic is eliminated, odd-order harmonics related to the fifth-order harmonic are also simultaneously eliminated. Likewise, when the third-, fifth- and seventh-order harmonics are simultaneously eliminated, the third-, fifth-, seventh-, and ninth-order harmonics are eliminated, and it follows that all the single-digit harmonics can be eliminated.

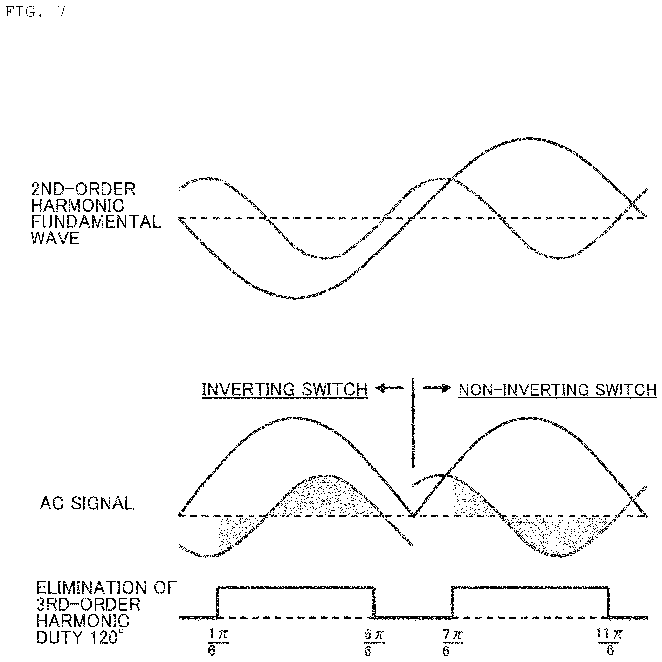

Note that, as illustrated in FIG. 7, when, e.g., the third-order harmonic is to be eliminated, an even-order harmonic noise component of the carrier frequency has a reverse-polarity dc component resulting from integration of the inverted signal and the non-inverted signal with each other. Since a positive-side area and a negative-side area in a portion overlapping the pulse duty are equal to each other and are cancelled out, the even-order harmonic noise component does not appear in the output.

As a method of generating the pulse duty, when settings exactly as illustrated in the setting example in FIG. 3 are made using a microcomputer or the like, high-accuracy harmonic elimination as illustrated in FIGS. 5A to 5D is possible. However, the pulse duty can also be generated as follows, though the accuracy of harmonic elimination slightly decreases.

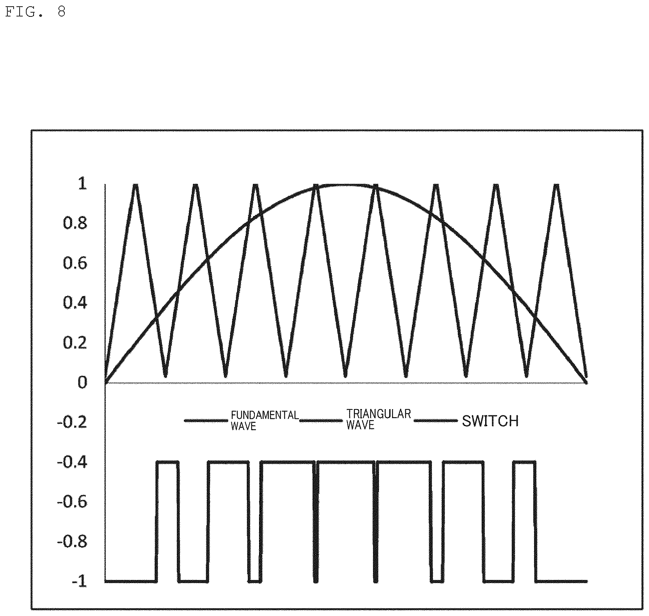

In other words, as the pulse duty, a duty that generates a sine wave PWM can be used. The duty that generates the sine wave PWM is obtained by dividing one period of a sine wave into a plurality of time periods and determining, for each of the time periods resulting from the division, a duty of a rectangular wave having an average amplitude substantially equal to an average amplitude of the sine wave. For example, as illustrated in FIG. 8, respective amplitudes of the sine wave from the oscillator and a triangular wave of a PWM frequency are compared to each other, and the switch is turned ON during a period during which the amplitude of the sine wave is larger. Thus, the pulse duty is generated by simple processing, and the harmonic noise can be eliminated.

As described above, by setting the duty of each of the switches in the synchronous detection circuit to the specified value, it is possible to eliminate, from the displacement signal after the detection, switching noise of odd-order harmonic components of the sensor carrier frequency with which the displacement sensor signal is contaminated. Therefore, it is possible to implement a low-vibration and low-noise magnetic bearing device with no need to add a high-cost component and without increasing cost.

Next, a description will be given of a method of eliminating high-frequency switching spike noise generated in the electromagnet power amplifiers or in the inverter for driving the motor 121.

In the turbo molecular pump 100, the electromagnet power amplifiers and the inverter for driving the motor 121 perform PWM control over power. At the moment when each of the switches is turned ON/OFF during a power switching operation, an abrupt voltage change occurs in the electromagnets and in the motor 121, and consequently extremely-high-frequency switching spike noise may be generated.

The spike noise has an extremely short duration time compared to one period of the displacement sensor and a high frequency. Accordingly, when the sensor signal is contaminated also with the spike noise, the spike noise may appear in a dc signal from the displacement sensor.

In the present embodiment, there is the zero output (no input) mode in which the sensor signal is not transmitted to the output. Therefore, by controlling the power switch circuit such that power switches are turned ON/OFF during the zero output period, the spike noise is prevented from contaminating the sensor signal.

Specifically, power switching frequencies of the electromagnet power amplifiers and the inverter for driving the motor 121 are synchronized with an even order of the carrier frequency of the displacement sensor to effect ON/OFF timing for the power switches in the vicinity of 0 degrees and 180 degrees of a sine fundamental wave of the sensor.

Note that, when the power switching frequencies are synchronized with an odd order of the carrier frequency of the displacement sensor, the odd order of the carrier frequency is likely to appear in the sensor output, and therefore the synchronization of the power switching frequency with the odd order of the carrier frequency is preferably avoided.

Due to the PWM control, the ON/OFF timing for the power switches varies around a center value, but is overall concentrated on the vicinities of the 0 degrees and the 180 degrees of the sine fundamental wave.

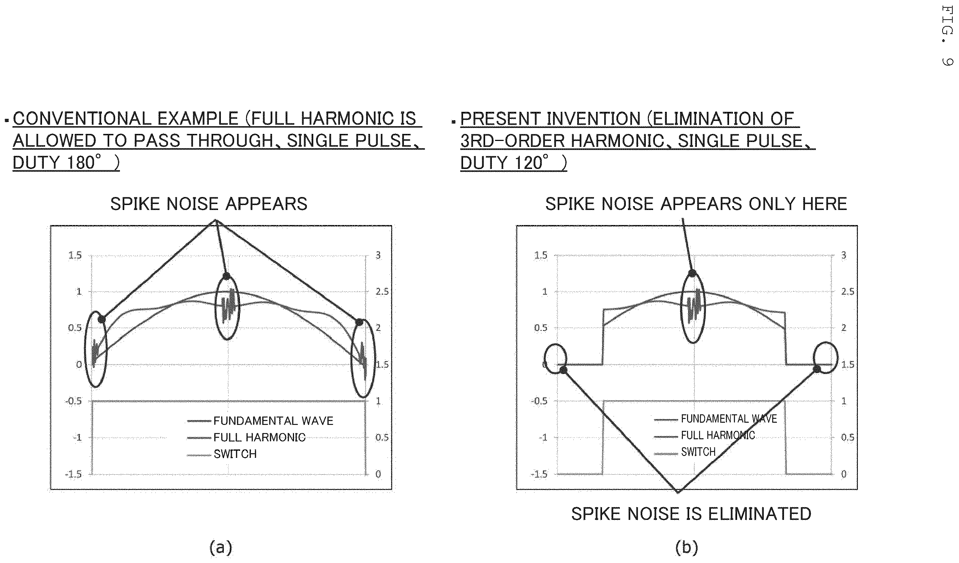

FIG. 9A illustrates a fundamental wave to be originally detected, combined third-, fifth-, and seventh-order harmonic noise, and a waveform (full harmonic) contaminated with the spike noise in the conventional example. At this time, a pulse is a monopulse, and the detection duty is 180 degrees.

By contrast, FIG. 9B illustrates waveforms when, to eliminate the third-order harmonic, a monopulse is used, and the detection duty is changed to 120 degrees. In addition, an ordinate axis represents a value of a dc component. As can be seen from a comparison between FIGS. 9A and 9B, the spike noise conventionally observed in the vicinities of the 0 degree and the 180 degree has disappeared.

In other words, by concentrating the ON/OFF timing for each of the electromagnet power amplifier switches during normal operation or the like on the vicinities of 0 degrees and 180 degrees of the sensor carrier of the displacement sensor and setting the switch of the sensor in the vicinity thereof to the zero output, it is possible to reduce the possibility of contamination of the sensor signal with noise from the electromagnet power amplifiers or the like.

Note that, various modifications can be made in the present invention without departing from the spirit of the present invention. The embodiment and the individual modifications each described above can variously be combined with each other.

| 1, 3 | Oscillator |
| --- | --- |
| 7 | Bandpass filter |
| 9 | Inverting amplifier |
| 11 | Non-inverting amplifier |
| 13 | Inverting switch |
| 15 | Non-inverting switch |
| 17, 19, 29 | Operation signal |
| 21 | Connection point |
| 23 | Smoothing circuit |
| 25 | Ground |
| 27 | Zero switch |
| 100 | Turbo molecular pump |
| 104 | Upper radial electromagnet |
| 105 | Lower radial electromagnet |
| 107 | Upper radial sensor |
| 108 | Lower radial sensor |
| 113 | Rotor shaft |
| 121 | Motor |

## Claims

1. A harmonic elimination circuit that eliminates a harmonic signal from an ac waveform signal on which the harmonic signal is superimposed, wherein
a duty of a pulse synchronized with the ac waveform signal is set such that a positive-side area and a negative-side area of the harmonic signal are equal to each other.

2. The harmonic elimination circuit according to claim 1, wherein the duty of the pulse is generated through switching to any of an output resulting from inverting amplification, an output resulting from non-inverting amplification, or a zero output.

3. The harmonic elimination circuit according to claim 1 or 2, wherein

   the pulse includes at least one pulse during a half period of the ac waveform signal, and
   the duty of the pulse is symmetrically generated with respect to a peak value of the ac waveform signal in a phase progression direction.

4. The harmonic elimination circuit according to claim 1, 2, or 3, wherein, to eliminate a third-order harmonic, the pulse is generated from one pulse having a duty of $2\Pi/3$ [rad] during the half period of the ac waveform signal.

5. The harmonic elimination circuit according to claim 1, 2, or 3, wherein, to eliminate a fifth-order harmonic, the pulse is generated from one pulse having a duty of $4\Pi/5$ [rad] during the half period of the ac waveform signal.

6. The harmonic elimination circuit according to claim 1, 2, or 3, wherein, to eliminate a seventh-order harmonic, the pulse is generated from one pulse having a duty of $6\Pi/7$ [rad] during the half period of the ac waveform signal.

7. The harmonic elimination circuit according to claim 1, 2, or 3, wherein, to simultaneously eliminate a third-order harmonic and a fifth-order harmonic, the pulse is generated from three pulses each having a duty of $2\Pi/3$ [rad] during the half period of the ac waveform signal.

8. The harmonic elimination circuit according to claim 1, 2, or 3, wherein, to simultaneously eliminate a third-order harmonic and a seventh-order harmonic, the pulse is generated from three pulses each having a duty of $2\Pi/3$ [rad] during the half period of the ac waveform signal.

9. The harmonic elimination circuit according to claim 1, 2, or 3, wherein, to simultaneously eliminate a third-order harmonic, a fifth-order harmonic, and a seventh-order harmonic, the pulse is generated from seven pulses each having a duty of $2\Pi/3$ [rad] during the half period of the ac waveform signal.

10. The harmonic elimination circuit according to any one of claims 1 to 9, wherein, as the duty of the pulse, a duty that generates a sine wave PWM is used.

11. The harmonic elimination circuit according to claim 2, wherein a switch that disconnects and connects power is controlled with timing of the zero output.

12. A position detection device comprising:

a position detection unit that detects a position of an object;
a carrier-wave-signal supply unit that supplies a carrier wave signal to the position detection unit; and
a detection unit that detects a position signal resulting from the detection by the position detection unit through switching using a switch synchronized with the carrier wave signal, wherein
the position signal is formed of an ac waveform signal on which a harmonic signal is superimposed, and
a duty of a pulse that drives the switch is set such that a positive-side area and a negative-side area of the harmonic signal are equal to each other.

13. A magnetic bearing device comprising:

a position detection unit that detects a position of an object in non-contact relation;
a magnetic bearing unit that controls the position of the object by using an electromagnet;
a carrier-wave-signal supply unit that supplies a carrier wave signal to the position detection unit; and
a detection unit that detects a position signal resulting from the detection by the position detection unit through switching using a switch synchronized with the carrier wave signal, wherein
the position signal is formed of an ac waveform signal on which a harmonic signal is superimposed, and
a duty of a pulse that drives the switch is set such that a positive-side area and a negative-side area of the harmonic signal are equal to each other.

14. A vacuum pump comprising:

a rotating body;
a position detection unit that detects a position of the rotating body in non-contact relation;
a magnetic bearing unit that controls the position of the rotating body by using an electromagnet;
a carrier-wave-signal supply unit that supplies a carrier wave signal to the position detection unit; and
a detection unit that detects a position signal resulting from the detection by the position detection unit through switching using a switch synchronized with the carrier wave signal, wherein
the position signal is formed of an ac waveform signal on which a harmonic signal is superimposed, and
a duty of a pulse that drives the switch is set such that a positive-side area and a negative-side area of the harmonic signal are equal to each other.

FIG. 1

OSCILLATOR 1

107,108
SENSOR COIL

−X

+X

5

3

BANDPASS FILTER

7

AMPLIFIER

9

AC SIGNAL

11

SWITCH 13

ON SIGNAL 17

29

15

19

25

27

21

DC SIGNAL

SMOOTHING CIRCUIT

DC OUTPUT SIGNAL

23

FIG. 2

POSITIVE-SIDE AREA IS LARGER
BY AREA CORRESPONDING TO
HALF WAVE, AND ACCORDINGLY
POSITIVE NOISE APPEARS IN
OUTPUT

FUNDAMENTAL
WAVE
3RD-ORDER
HARMONIC

FIG. 3

EP 4 108 945 A1

TABLE SHOWING TIMING OF TURNING ON/OFF INVERTING SWITCH WITH RESPECT TO ANGLE (0 TO π) OF HALF SINE WAVE OF FUNDAMENTAL WAVE

| HARMONIC TO BE ELIMINATED, NUMBER OF PULSES, TOTAL DUTY | ANGLE AT WHICH EACH OF SWITCHES IS TO BE TURNED ON | ANGLE AT WHICH EACH OF SWITCHES IS TO BE TURNED OFF |
|---|---|---|
| ELIMINATION OF 3RD-ORDER HARMONIC<br>MONOPULSE<br>DUTY 120° =(2/3)π | $(\pi/6)$ | $(5\pi/6)$ |
| ELIMINATION OF 5TH-ORDER HARMONIC<br>MONOPULSE<br>DUTY 144° =(4/5)π | $(\pi/10)$ | $(9\pi/10)$ |
| ELIMINATION OF 7TH-ORDER HARMONIC<br>MONOPULSE<br>DUTY 154.3° =(6/7)π | $(\pi/14)$ | $(13\pi/14)$ |
| SIMULTANEOUS ELIMINATION OF 3RD-ORDER AND 5TH-ORDER HARMONICS<br>3 PULSES<br>DUTY 120° =(2/3)π | $(\pi/10)$、$(7\pi/30)$、$(5\pi/6)$ | $(\pi/6)$、$(23\pi/30)$、$(9\pi/10)$ |
| SIMULTANEOUS ELIMINATION OF 3RD-ORDER AND 7TH-ORDER HARMONICS<br>3 PULSES<br>DUTY 120° =(2/3)π | $(5\pi/42)$、$(3\pi/14)$、$(5\pi/6)$ | $(\pi/6)$、$(11\pi/14)$、$(37\pi/42)$ |
| SIMULTANEOUS ELIMINATION OF 3RD-ORDER, 5TH-ORDER, AND 7TH-ORDER HARMONICS<br>7 PULSES<br>DUTY 120° =(2/3)π | $(\pi/70)$、$(5\pi/42)$、$(3\pi/14)$、<br>$(67\pi/210)$、$(7\pi/10)$、<br>$(5\pi/6)$、$(29\pi/30)$ | $(\pi/30)$、$(\pi/6)$、$(3\pi/10)$、<br>$(143\pi/210)$、$(11\pi/14)$、<br>$(37\pi/42)$、$(69\pi/70)$ |

FIG. 4

FUNDAMENTAL WAVE — 0 ... $\pi$ — (a)

CONVENTIONAL EXAMPLE DUTY 180° $=\pi$ — 0 ... $\pi$ — (b)

ELIMINATION OF 3RD-ORDER HARMONIC DUTY 120° $=(2/3)\pi$ — $\dfrac{\pi}{6}$ ... $\dfrac{5\pi}{6}$ — (c)

ELIMINATION OF 5TH-ORDER HARMONIC DUTY 144° $=(4/5)\pi$ — $\dfrac{\pi}{10}$ ... $\dfrac{9\pi}{10}$ — (d)

ELIMINATION OF 7TH-ORDER HARMONIC DUTY 154.3° $=(6/7)\pi$ — $\dfrac{\pi}{14}$ ... $\dfrac{13\pi}{14}$ — (e)

SIMULTANEOUS ELIMINATION OF 3RD- AND 5TH-ORDER HARMONICS DUTY 120° $=(2/3)\pi$ — $\dfrac{\pi}{10}$ $\dfrac{\pi}{6}$ $\dfrac{7\pi}{30}$ ... $\dfrac{23\pi}{30}$ $\dfrac{5\pi}{6}$ $\dfrac{9\pi}{10}$ — (f)

SIMULTANEOUS ELIMINATION OF 3RD- AND 7TH-ORDER HARMONICS DUTY 120° $=(2/3)\pi$ — $\dfrac{5\pi}{42}$ $\dfrac{\pi}{6}$ $\dfrac{3\pi}{14}$ ... $\dfrac{11\pi}{14}$ $\dfrac{5\pi}{6}$ $\dfrac{37\pi}{42}$ — (g)

SIMULTANEOUS ELIMINATION OF 3RD-, 5TH-, AND 7TH-ORDER HARMONICS DUTY 120° $=(2/3)\pi$ — $\dfrac{\pi}{70}$ $\dfrac{\pi}{30}$ $\dfrac{5\pi}{42}$ $\dfrac{\pi}{6}$ $\dfrac{3\pi}{14}$ $\dfrac{3\pi}{10}$ $\dfrac{67\pi}{210}$ ... $\dfrac{143\pi}{210}$ $\dfrac{7\pi}{10}$ $\dfrac{11\pi}{14}$ $\dfrac{5\pi}{6}$ $\dfrac{37\pi}{42}$ $\dfrac{29\pi}{30}$ $\dfrac{69\pi}{70}$ — (h)

FIG. 5

• CONVENTIONAL EXAMPLE (FULL HARMONIC IS
ALLOWED TO PASS THROUGH、MONOPULSE、
DUTY 180° )

FUNDAMENTAL WAVE DC COMPONENT   = 0.636

DC COMPONENT AT TIME OF
HARMONIC NOISE CONTAMINATION   = 0.699

(NOISE COMPONENT = 9.9%)

(a)

• PRESENT INVENTION (ELIMINATION OF 3RD-ORDER
HARMONIC、MONOPULSE、DUTY 120° )

FUNDAMENTAL WAVE DC COMPONENT   = 0.550

DC COMPONENT AT TIME OF
HARMONIC NOISE CONTAMINATION   = 0.537

(NOISE COMPONENT = 2.5%)

(b)

• PRESENT INVENTION (ELIMINATION OF 3RD- AND
5TH-ORDER HARMONICS、3 PULSES、DUTY 120° )

FUNDAMENTAL WAVE DC COMPONENT   = 0.526

DC COMPONENT AT TIME OF
HARMONIC NOISE CONTAMINATION   = 0.530

(NOISE COMPONENT = 0.7%)

(c)

• PRESENT INVENTION (ELIMINATION OF 3RD-、5TH-、
AND 7TH-ORDER HARMONICS、7 PULSES、DUTY 120° )

FUNDAMENTAL WAVE DC COMPONENT   = 0.510

DC COMPONENT AT TIME OF
HARMONIC NOISE CONTAMINATION   = 0.510

(NOISE COMPONENT = 0.0%)

(d)

FIG. 6

FUNDAMENTAL WAVE

INVERTING SWITCH

ZERO-OUTPUT SWITCH

NON-INVERTING SWITCH

FIG. 7

2ND-ORDER
HARMONIC
FUNDAMENTAL
WAVE

INVERTING SWITCH ◄————► NON-INVERTING SWITCH

AC SIGNAL

ELIMINATION OF
3RD-ORDER
HARMONIC
DUTY 120°

$\dfrac{1\pi}{6}$ $\qquad$ $\dfrac{5\pi}{6}$ $\dfrac{7\pi}{6}$ $\qquad$ $\dfrac{11\pi}{6}$

FIG. 8

FIG. 9

EP 4 108 945 A1

■ CONVENTIONAL EXAMPLE (FULL HARMONIC IS
ALLOWED TO PASS THROUGH、SINGLE PULSE、
DUTY 180°  )

■ PRESENT INVENTION (ELIMINATION OF
3RD-ORDER HARMONIC、SINGLE PULSE、
DUTY 120°  )

SPIKE NOISE APPEARS

SPIKE NOISE APPEARS ONLY HERE

FUNDAMENTAL WAVE
FULL HARMONIC
SWITCH

FUNDAMENTAL WAVE
FULL HARMONIC
SWITCH

SPIKE NOISE IS ELIMINATED

(a)

(b)

FIG. 10

100

FIG. 11

**INTERNATIONAL SEARCH REPORT**

| International application No. |
|---|
| PCT/JP2021/005104 |

**A. CLASSIFICATION OF SUBJECT MATTER**

F16C 32/04(2006.01)i; G01B 7/00(2006.01)i; G01D 5/12(2006.01)i; H03B 1/04(2006.01)i; F04D 19/04(2006.01)i
FI: H03B1/04; F16C32/04 A; G01B7/00 102M; F04D19/04 A; G01D5/12 C

According to International Patent Classification (IPC) or to both national classification and IPC

**B. FIELDS SEARCHED**

Minimum documentation searched (classification system followed by classification symbols)
F16C32/04; G01B7/00; G01D5/12; H03B1/04; F04D19/04

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2015-122701 A (HIOKI E.E. CORPORATION) 02 July 2015 (2015-07-02) paragraphs [0019]-[0064], fig. 1-2 | 1-4, 11<br>12-14<br>5-10 |
| Y<br>A | JP 2006-317419 A (BOC EDWARDS KK.) 24 November 2006 (2006-11-24) paragraphs [0004]-[0032], fig. 10-11 | 12-14<br>5-10 |
| A | JP 56-150973 A (SANKEN ELECTRIC CO., LTD.) 21 November 1981 (1981-11-21) page 2, lower left column, line 4 to lower right column, line 2, fig. 1 | 5-10 |
| A | WO 2011/135695 A1 (HITACHI, LTD.) 03 November 2011 (2011-11-03) paragraphs [0121]-[0124], fig. 14 | 5-10 |

☒ Further documents are listed in the continuation of Box C.      ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 April 2021 (13.04.2021) | 27 April 2021 (27.04.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2021/005104

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-148221 A (MURATA MACHINERY, LTD.) 01 July 2010 (2010-07-01) paragraph [0025], fig. 3 | 5-10 |

Form PCT/ISA/210 (continuation of second sheet) (January 2015)

| Patent Documents referred in the Report | Publication Date | Patent Family | Publication Date |
|---|---|---|---|
| | | INTERNATIONAL SEARCH REPORT<br>Information on patent family members | International application No.<br>PCT/JP2021/005104 |
| JP 2015-122701 A | 02 Jul. 2015 | (Family: none) | |
| JP 2006-317419 A | 24 Nov. 2006 | (Family: none) | |
| JP 56-150973 A | 21 Nov. 1981 | (Family: none) | |
| WO 2011/135695 A1 | 03 Nov. 2011 | (Family: none) | |
| JP 2010-148221 A | 01 Jul. 2010 | (Family: none) | |

Form PCT/ISA/210 (patent family annex) (January 2015)

**EP 4 108 945 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006317419 A